# EUROPEAN PATENT APPLICATION

(11) **EP 4 648 095 A1**
(43) Date of publication of application: **12.11.2025**
(21) Application number: 23866633.3
(22) Date of filing: 14.07.2023
(51) Int. Cl.: H01L 23/31, H01L 23/48, H01L 21/56

(54) **SEMICONDUCTOR DEVICE ASSEMBLY AND PREPARATION METHOD THEREFOR AND USE THEREOF**

(30) Priority: 06.01.2023 CN 202310015717
(71) Applicant: Chongqing Alpha and Omega Semiconductor Limited, Chongqing 400700 (CN)
(72) Inventor: WANG, Limin, Chongqing 400700 (CN); HUANG, Xin, Chongqing 400700 (CN)
(74) Representative: Metida
(86) International application number: PCT/CN2023/107418
(87) International publication number: WO 2024/078079

(57) **Abstract**

A semiconductor device assembly, a preparation method therefor, and a use thereof are provided. The semiconductor device assembly includes metal frames, semiconductor device units, and chip stages. The semiconductor device units include chips, pins, and connectors. The semiconductor device units are paired to form at least one semiconductor device pair, and are arranged in sequence along a length direction or a width direction of the metal frames. Encapsulation layers are arranged along an arrangement direction of the semiconductor device units. A redundant frame structure configured to carry and isolate single products of the metal frames is simplified, thereby increasing a density of the single products on each of the metal frames by at least 30%, facilitating cutting of the semiconductor device assembly, and facilitating bending of the pins exposed outside after cutting, so as to ensure that the pins meet design requirements in specific occasions.

## Description

### TECHNICAL FIELD

The present disclosure relates to a technical field of semiconductor pieces manufacturing, in particular to a semiconductor device assembly, a preparation method therefor, and a use thereof, and specifically related to a semiconductor encapsulation layer including copper clips or bonding wires (gold wires/copper wires/aluminum wires/aluminum strips), a method for forming, cutting, separation of the semiconductor encapsulation layer, and a use thereof.

### BACKGROUND

Currently, there are generally two production methods for manufacturing power semiconductor discrete devices. A first production method is to produce a single power semiconductor discrete device through conventional plastic packaging. Therefore, it is necessary to design a mold, flow channels, and matching metal frame connection structure (metal frame for carrying a plurality of single power semiconductor discrete devices) corresponding to the single power semiconductor discrete device. In the first production method, it is necessary to reserve enough space next to a cavity of the mold for molding primary and secondary flow channels. In the first production method, since space must be reserved for the molding primary and secondary flow channels, each of the single power semiconductor discrete devices on the metal frame needs to be individually positioned and isolated, which results in the metal frame having a large useless area. Each of the single power semiconductor discrete devices occupies a large area on the metal frame, so a density of the single power semiconductor discrete devices on the metal frame is generally low.

The second production method is to modularly integrate the power semiconductor discrete devices. That is, the power semiconductor discrete devices are regularly arranged in horizontal and vertical formats in the metal frame and a mold thereof are also designed in block format. Flow channels thereof are no longer connected to the power semiconductor discrete devices but are connected to each other through a block design (the power semiconductor discrete devices are integrated together), thereby increasing the density of the power semiconductor discrete devices on the metal frame. However, the second production method limits an appearance of the power semiconductor discrete devices. Moreover, since a blade cutting method is adopted to separate the power semiconductor discrete devices, exposed pins of the power semiconductor discrete devices need to be on the same plane as a cutting surface of the power semiconductor discrete devices, thus limiting use of the power semiconductor discrete devices in specific applications.

### SUMMARY

**In** view of deficiencies in the prior art, a first purpose of the present disclosure is to provide a semiconductor device assembly. In the semiconductor device assembly, a structure of the metal frames configured to carry and isolate single products of the semiconductor device assembly is simplified, a density of the single products on each of the metal frames is increased, production costs are reduced, and reliability of the semiconductor device assembly is improved. Therefore, it is ensured that pins thereof are allowed to be bent to meet design requirements in specific occasions.

The semiconductor device assembly comprises metal frames and semiconductor device units.

The metal frames comprise chip stages. The semiconductor device units comprise chips, pins, and connectors. The chips and the pins are arranged above the metal frames. Each of the connectors is configured to electrically connect an electrode of a corresponding chip with a corresponding pin. The semiconductor device units are paired to form at least one semiconductor device pair. Each of the chips is arranged on a corresponding chip stage. The pins of each semiconductor device pair are connected. The connectors of each semiconductor device pair are away from each other. The semiconductor device units are arranged in sequence along a length direction of the metal frames or a width direction of the metal frames. Encapsulation layers are arranged along an arrangement direction of the semiconductor device units. The encapsulation layers are arranged above the chip stages.

A second purpose of the present disclosure is to provide a preparation method of a semiconductor device assembly. The preparation method comprises steps A-C.

The step A comprises mounting chips on metal frames.

The step B comprises mounting two connectors of each of semiconductor device pairs on corresponding chips and arranging the two connectors of each of the semiconductor device pairs along a width direction thereof. Each of the semiconductor device pairs comprises two semiconductor device units.

The step C comprises integrally encapsulating the chips and the connectors arranged on the chip stages to obtain encapsulation layers.

A third purpose of the present disclosure is to provide a use of a semiconductor device assembly. The use comprises steps D and E.

The step D comprises cutting the semiconductor device assembly.

The step E comprises bending pins of the semiconductor device assembly to form a predetermined shape.

Furthermore, the step D comprises steps d1-d2.

The step d1 comprises cutting off connecting ribs of the semiconductor device assembly.

The step d2 comprises cutting encapsulation layers of the semiconductor device assembly to obtain single products.

The step E is performed between the step d1 and the step d2, or, the step E is performed after the step d2.

Compared with the prior art, the present disclosure has following characteristics.

In the semiconductor device assembly, layouts of the metal frames and the semiconductor device units are specifically designed. The metal frames comprise the chip stages. The semiconductor device units comprise the chips, the pins, and the connectors. The semiconductor device units are paired to form the at least one semiconductor device pair. The pins of each semiconductor device pair are connected. The semiconductor device units are arranged in sequence along the length direction or the width direction of the metal frames. The encapsulation layers are arranged along the arrangement direction of the semiconductor device units. A redundant frame structure configured to carry and isolate single products of the metal frames is simplified, thereby increasing a density of the single products on each of the metal frames, facilitating cutting of the semiconductor device assembly, and facilitating bending of the pins exposed outside after cutting, so as to ensure that the pins meet the design requirements in specific occasions. On a basis of a conventional density of single products of a conventional semiconductor device assembly, the density of the single products on each of the metal frames is significantly increased by at least 30%.

In the preparation method and the use of the present disclosure, the layout of the semiconductor device assembly is first design and then the semiconductor device assembly is manufactured, integrally plastic packaged, and then cut to form the single products, thereby reducing production costs. The semiconductor device assembly is separated by cutting. Optionally, the semiconductor device assembly is separated by double-sided cutting, which reduces stress of mechanical stamping and cutting, thereby improving reliability of the single products. The pins of the single products that are exposed outside are allowed to be processed through cutting the connecting ribs, bending, and cutting separation technology, thereby ensuring that the pins meets the design requirements for specific occasions.

### BRIEF DESCRIPTION OF DRAWINGS

FIG. 1 is a perspective schematic diagram of a semiconductor device assembly according to Embodiment 1 of the present disclosure.
FIG. 2 is an exploded perspective schematic diagram of the semiconductor device assembly according to Embodiment 1 of the present disclosure.
FIG. 3 is a partial exploded perspective schematic diagram of the semiconductor device assembly according to Embodiment 1 of the present disclosure.
FIG. 4 is an elevational schematic diagram of the semiconductor device assembly according to Embodiment 1 of the present disclosure.
FIG. 5 is another elevational schematic diagram of the semiconductor device assembly according to Embodiment 1 of the present disclosure.
FIG. 6 is a flow chart of a preparation method of the semiconductor device assembly according to Embodiment 2 of the present disclosure.

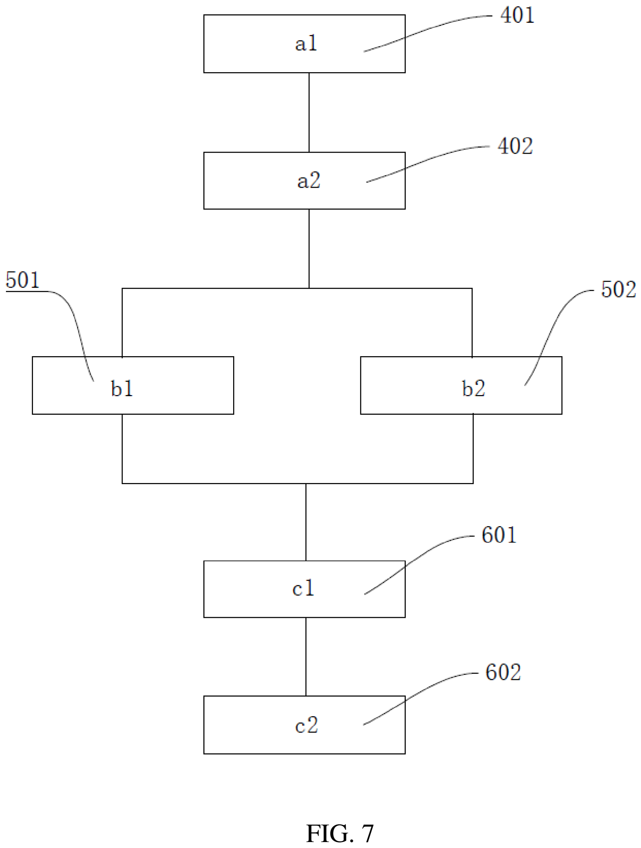

FIG. 7 is another flow chart of the preparation method of the semiconductor device assembly according to Embodiment 2 of the present disclosure.
FIG. 8 is a flow chart of a use of the semiconductor device assembly according to Embodiment 3 of the present disclosure.

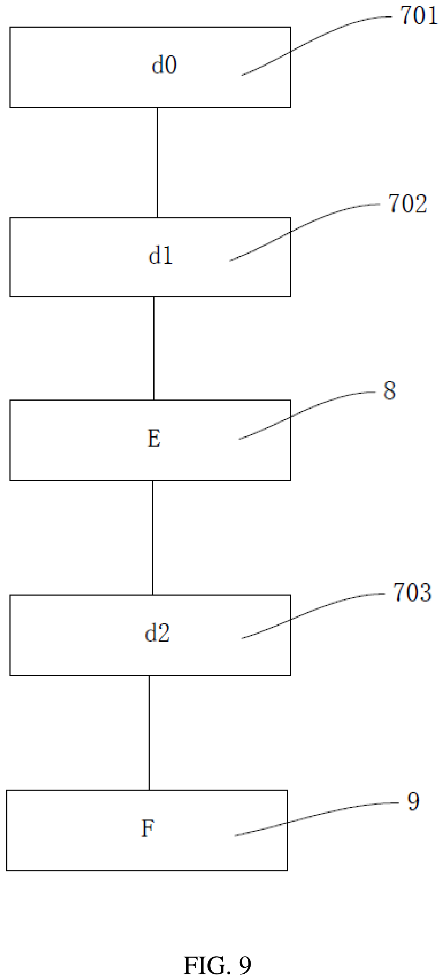

FIG. 9 is another flow chart of the use of the semiconductor device assembly according to Embodiment 3 of the present disclosure.
FIG. 10 is a perspective schematic diagram of single products obtained by the use of the semiconductor device assembly according to Embodiment 3 of the present disclosure.
FIG. 11 is an exploded perspective schematic diagram of single products obtained by the use of the semiconductor device assembly according to Embodiment 3 of the present disclosure.

### DETAILED DESCRIPTION

### Embodiment 1

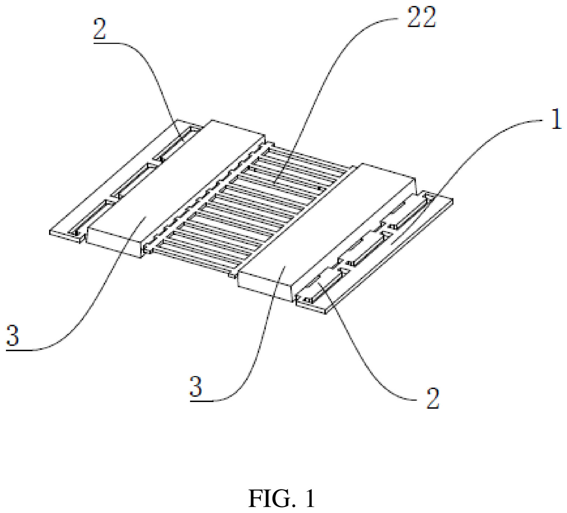

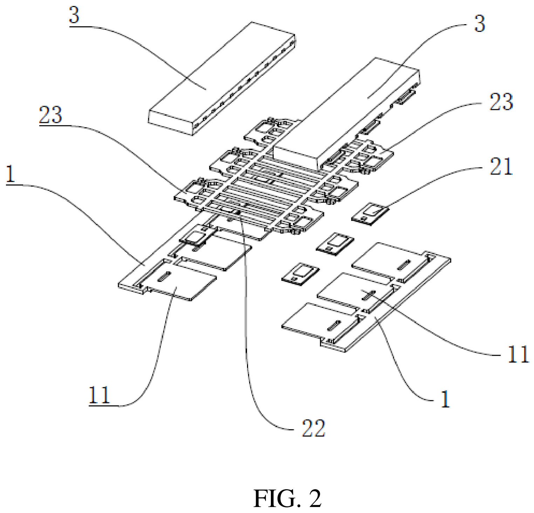

As shown in FIGS. 1-2, the embodiment provides a semiconductor device assembly. The semiconductor device assembly comprises metal frames 1 and six semiconductor device units 2. The metal frames 1 comprise six chip stages 11.

The semiconductor device units comprise chips 21, pins 22, and connectors 11. Each of the semiconductor device units comprises a chip 21, pins 22, and a connector 11 connecting the chip 21 and the pins 22 thereof. The chips 21 and the pins 22 are arranged above the metal frames 1.

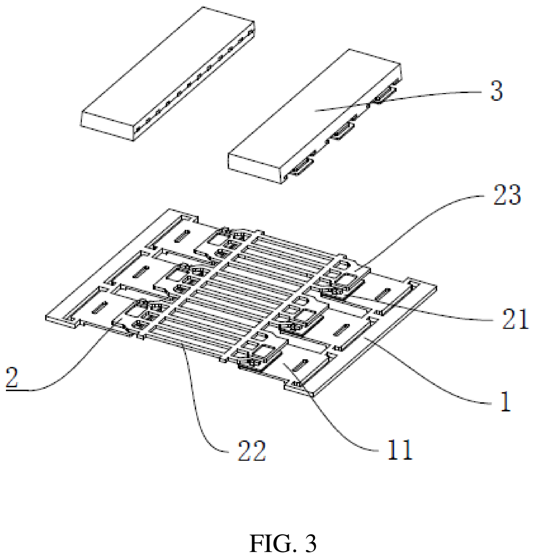

As shown in FIG. 3, in one optional embodiment, the connectors 23 are copper clips. In one alternative embodiment, the connectors are bonding wires. The bonding wires are selected from gold wires, copper wires, aluminum wires, aluminum strips, or a combination thereof. Each of the chips 21 and corresponding pins 22 are connected through bonding technology, so that an electrode of each of the chips is electrically connected with the corresponding pins 22.

In one embodiment, the semiconductor device units 2 are paired to form three semiconductor device pairs. Each of the chips 21 is arranged on a corresponding chip stage 11. The pins 22 of each semiconductor device pair are connected. The connectors 23 of each semiconductor device pair are away from each other.

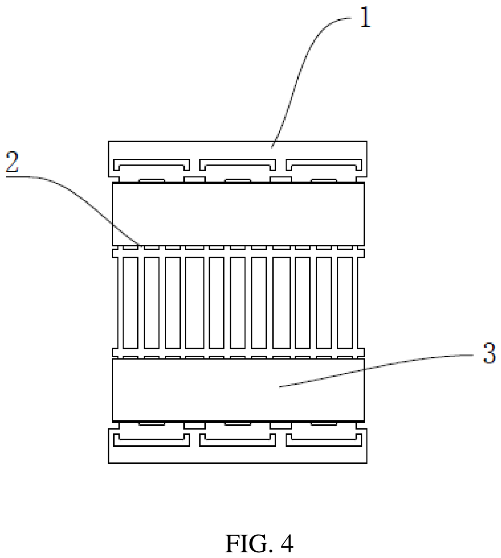

As shown in FIG. 4, the three semiconductor device pairs are arranged in sequence along a width direction of the semiconductor device units 2. That is, the three semiconductor device pairs are arranged in sequence along a width direction of the metal frames 1. Two encapsulation layers 3 are arranged along an arrangement direction of the three semiconductor device pairs. The encapsulation layers 3 are arranged above the chip stages 11. The encapsulation layers 3 respectively wrap the chips 21 and the connectors 23 that are arranged in two columns.

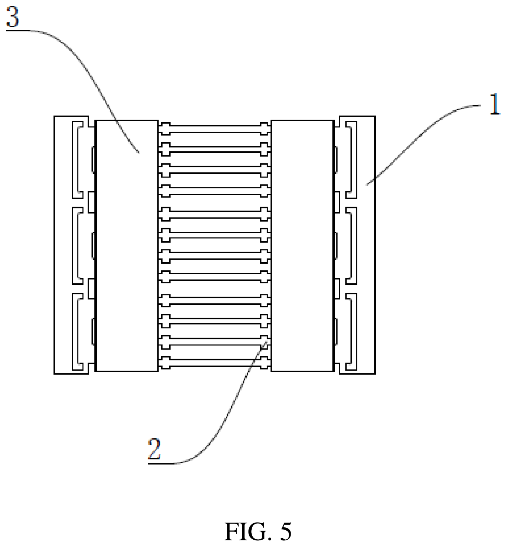

As shown in FIG. 5, in another embodiment, the three semiconductor device pairs are arranged in sequence along a width direction of the semiconductor device units 2. That is, the three semiconductor device pairs are arranged in sequence along a length direction of the metal frames 1. Two encapsulation layers 3 are arranged along an arrangement direction of the three semiconductor device pairs. The encapsulation layers 3 are arranged above the chip stages 11. The encapsulation layers 3 respectively wrap the chips 21 and the connectors 23 that are arranged in two columns.

In the semiconductor device assembly, a redundant frame structure configured to carry and isolate single products of the metal frames is simplified, thereby increasing a density of the single products on each of the metal frames. On a basis of a conventional density of single products of a conventional semiconductor device assembly, the density of the single products on each of the metal frames is significantly increased by at least 30%. Further, it also facilitates cutting of the semiconductor device assembly, and facilitating bending of the pins 22 exposed outside after cutting, so as to ensure that the pins 22 meet the design requirements in specific occasions.

### Embodiment 2

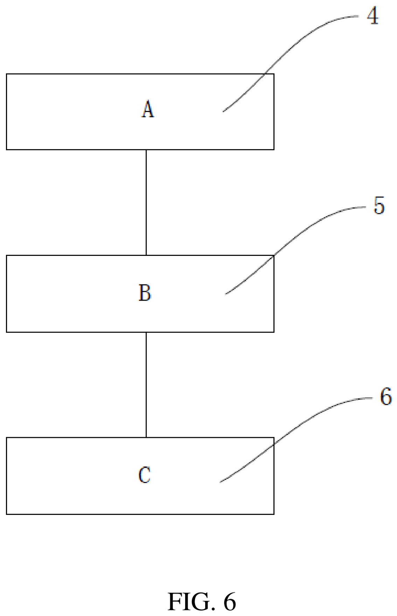

As shown in FIG. 6, the embodiment provides a preparation method of the semiconductor device assembly. The preparation method comprises steps A-C.

The step A comprises mounting the chips 21 on the metal frames 1.

The step B comprises mounting two connectors 23 of each of the semiconductor device pairs on corresponding chips 21 and arranging the two connectors 23 of each of the semiconductor device pairs along a width direction thereof.

The step C comprises integrally encapsulating the chips 21 and the connectors 23 arranged on the chip stages 11 to obtain the encapsulation layers 3 along the arrangement direction of the semiconductor device units 2.

In one specific embodiment, the step A comprises steps a1 and a2.

The step a1 comprises chip preparation, specifically, checking whether there is a film on a back surface of a wafer, if no, attaching the film to the back surface of the wafer and then performing the wafer cutting on the wafer to obtain the chips 21.

After all preparations for cutting are completed on a wafer, groove cutting is performed sequentially to cut the wafer to into the chips 21 that are separated from each other. If the chips 21 are prepared in advance, the step a1 is omitted.

In one embodiment, when the silver paste is coated on the chip stages 11, baking to fix the chips 21 through an oven.

The step a2 comprises chip mounting. Specifically, coating silver paste or solder paste on predetermined areas (i.e., the chip stages 11) of the metal frames 1, sucking the chips 21 and placing the chips 21 on the silver paste or the solder paste by a machine.

In one alternative embodiment, when the solder paste is pasted on the chip stages, performing reflow soldering separately or performing the reflow soldering in the step B.

In one alternative embodiment, when the solder paste is pasted on the chip stages, performing reflow soldering separately or performing the reflow soldering in the step B.

In one specific embodiment, the step B comprises steps b1 and b2.

The step b1 comprises when the connectors 23 of the semiconductor device units 2 are copper clips, coating the solder paste on the chips 21 and the chip stages of the metal frames 1, placing the pins 22 of the semiconductor device units 2 and the copper clips on the solder paste for positioning, and performing reflow soldering in a reflow oven to melt the solder paste for eutectic soldering. The solder paste is coated between the chips and the metal frames or the solder paste is coated between the chips and the metal clip assemblies.

The step b2 comprises when the connectors 23 of the semiconductor device units 2 are bonding wires, connecting each of the pins 22 with a corresponding chip 21 through bonding.

The steps b1 and b2 are alternatively performed. Optionally, an effect of the step b1 is better.

In one specific embodiment, the step C comprises steps c1 and c2.

The step c1 comprises when the connectors 23 of the semiconductor device units 2 are the copper clips, performing chemical cleaning on the semiconductor device units 2. The step of performing the chemical cleaning comprises soaking the semiconductor device units with an ultrasonic chemical reagent for cleaning or cleaning the semiconductor device units by spraying a chemical reagent. The step c1 is conductive to reducing a risk of product stratification in subsequent processes.

The step c2 comprises integrally encapsulating the chips 21 and the connectors 23 with plastic encapsulation material along a width direction of the semiconductor device pairs and curing the semiconductor device pairs to obtain the encapsulation layers 3.

In the preparation method of the present disclosure, through a layout and a preparation of the semiconductor device assembly and through cutting and shaping after integrally plastic packaging, production costs are reduced.

### Embodiment 3

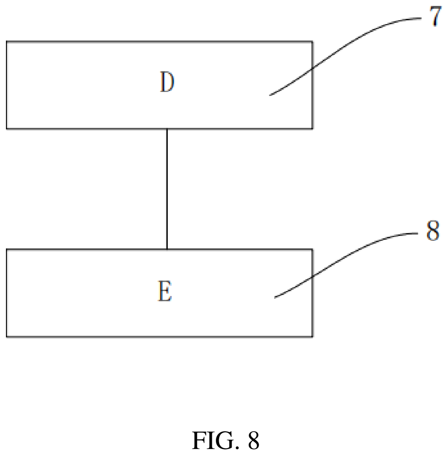

As shown in FIG. 8, the embodiment provides a use of the semiconductor device assembly. The use comprises steps D and E.

The step D comprises cutting the semiconductor device assembly.

The step E comprises bending the pins 22 of the semiconductor device assembly to form a predetermined shape.

In one specific embodiment, the step D comprises steps d0-d2.

The step d0 comprises removing flash left in a plastic packaging process and/or performing an electroplating operation.

The electroplating operation comprises removing impurities and organic matters on a surface of each of metal frames of the semiconductor device assembly, slightly corroding the surface of each of the metal frames, plating a tin layer on the surface of each of the metal frames, cleaning to remove chemical residues, and baking the semiconductor device assembly.

The step d1 comprises cutting off connecting ribs of the semiconductor device assembly.

The step E is performed between the step d1 and the step d2, or, the step E is performed after the step d2.

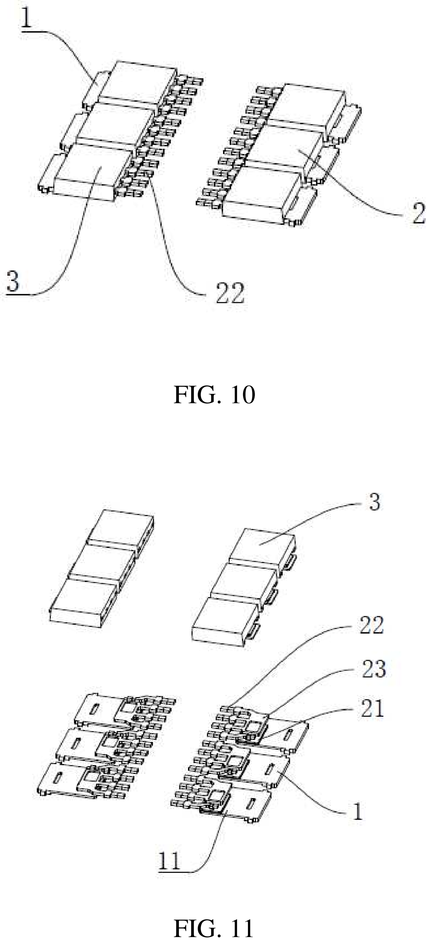

The step d2 comprises cutting the encapsulation layers 3 of the semiconductor device assembly to obtain single products. Optionally, the encapsulation layers 3 are cut from two sides to separate the single products shown in FIGS. 10-11 from the encapsulation layers 3.

After the step E, the use further comprises a step F. The step F comprises testing the single products to screen out appearance defective products and performed defective products according to an electrical performance requirement specification; selecting carrier tapes, the cover tapes, and packaging cartons for qualified products to package the qualified products; respectively attaching labels each containing complete product information to the packaging cartons; and storing the packaging cartons in a warehouse with a temperature and a humidity meeting a predetermined requirement and waiting for shipment.

In the use of the semiconductor device assembly, the semiconductor device assembly is separated by cutting. Optionally, the semiconductor device assembly is separated by double-sided cutting, which reduces stress of mechanical stamping and cutting, thereby improving reliability of the single products. The pins 22 of the single products that are exposed outside are allowed to be processed through cutting the connecting ribs, bending, and cutting separation technology, thereby ensuring that the pins 22 meets the design requirements for specific occasions.

## Claims

1. A semiconductor device assembly, comprising: metal frames (1) and semiconductor device units (2);
wherein the metal frames (1) comprise chip stages (11); the semiconductor device units (2) comprise chips (21), pins (22), and connectors (23); the chips (21) and the pins (22) are arranged above the metal frames (1); each of the connectors (23) is configured to electrically connect an electrode of a corresponding chip with a corresponding pin; the semiconductor device units (2) are paired to form at least one semiconductor device pair; each of the chips (21) is arranged on a corresponding chip stage; the pins (22) of each semiconductor device pair are connected; the connectors (23) of each semiconductor device pair are away from each other; the semiconductor device units (2) are arranged in sequence along a length direction of the metal frames (1) or a width direction of the metal frames (1); encapsulation layers (3) are arranged along an arrangement direction of the semiconductor device units (2); the encapsulation layers (3) are arranged above the chip stages (11).

2. The semiconductor device assembly according to claim 1, wherein the connectors (23) are copper clips or bonding wires.

3. The semiconductor device assembly according to claim 2, wherein the bonding wires are selected from gold wires, copper wires, aluminum wires, aluminum strips, or a combination thereof.

4. A preparation method of a semiconductor device assembly, comprising:
a step A: mounting chips (21) on metal frames (1);
a step B: mounting two connectors (23) of each of semiconductor device pairs on corresponding chips (21); arranging the two connectors (23) of each of the semiconductor device pairs along a width direction thereof; wherein each of the semiconductor device pairs comprises two semiconductor device units (2);
a step C: integrally encapsulating the chips (21) and the connectors (23) arranged on the chip stages (11) to obtain encapsulation layers (3).

5. The preparation method according to claim 4, wherein the step A comprises
a step a1: checking whether there is a film on a back surface of a wafer, if yes, performing wafer cutting; and if no, the film is adhered to the back surface of the wafer and then performing the wafer cutting on the wafer to obtain the chips (21); and
a step a2: coating silver paste or solder paste on the chip stages (11), placing the chips (21) on the silver paste or the solder paste; when the silver paste is coated on the chip stages (11), baking to fix the chips (21) through an oven when the solder paste is coated on the chip stages (11); when the solder paste is coated on the chip stages (11), performing reflow soldering separately or performing the reflow soldering in the step B.

6. The preparation method according to claim 4, wherein the step B comprises:
a step b1: when the connectors (23) of the semiconductor device units (2) are copper clips, coating the solder paste on the chips (21) and the chip stages (11) of the metal frames (1), placing pins (22) of the semiconductor device units (2) and the copper clips on the solder paste for positioning, performing reflow soldering in a reflow oven to melt the solder paste for eutectic soldering; wherein the solder paste is coated between the chips (21) and the metal frames (1) or the solder paste is coated between the chips (21) and the metal clip assemblies; and
a step b2: when the connectors (23) of the semiconductor device units (2) are bonding wires, connecting each of the pins (22) with a corresponding chip through bonding.

7. The preparation method according to claim 4, wherein the step C comprises:
a step c1: when the connectors (23) of the semiconductor device units (2) are copper clips, performing chemical cleaning on the semiconductor device units (2); wherein performing chemical cleaning comprises soaking the semiconductor device units (2) with an ultrasonic chemical reagent for cleaning or cleaning the semiconductor device units (2) by spraying a chemical reagent; and
a step c2: integrally encapsulating the chips (21) and the connectors (23) with plastic encapsulation material along a width direction of the semiconductor device pairs and curing the semiconductor device pairs to obtain the encapsulation layers (3).

8. A use of a semiconductor device assembly, comprising:
a step D: cutting the semiconductor device assembly; and
a step E: bending pins (22) of the semiconductor device assembly to form a predetermined shape;

9. The use according to claim 8, wherein the step D comprises:
a step d1: cutting off connecting ribs of the semiconductor device assembly; and
a step d2: cutting encapsulation layers (3) of the semiconductor device assembly to obtain single products;
wherein the step E is performed between the step d1 and the step d2, or, the step E is performed after the step d2.

10. The use according to claim 9, wherein before the step d1, the applicant further comprises:
a step d0: removing flash left in a plastic packaging process and/or performing an electroplating operation; wherein the electroplating operation comprises removing impurities and organic matters on a surface of each of metal frames (1) of the semiconductor device assembly, slightly corroding the surface of each of the metal frames (1), plating a tin layer on the surface of each of the metal frames (1), cleaning to remove chemical residues, and baking the semiconductor device assembly;
wherein after the step E, the use further comprises a step F; the step F comprises:
testing the single products to screen out appearance defective products and performed defective products according to an electrical performance requirement specification;
selecting carrier tapes, cover tapes, and packaging cartons for qualified products to package the qualified products;
respectively attaching labels each containing complete product information to the packaging cartons; and
storing the packaging cartons in a warehouse with a temperature and a humidity meeting a predetermined requirement and waiting for shipment.
